# EUROPEAN PATENT APPLICATION

(11) **EP 3 961 298 A1**
(43) Date of publication of application: **02.03.2022**
(21) Application number: 20203006.0
(22) Date of filing: 21.10.2020
(51) Int. Cl.: G02F 1/1333, B21D 5/00

(54) **COVER BOTTOM FOR DISPLAY DEVICE AND METHOD OF MANUFACTURING THE SAME**

(30) Priority: 28.08.2020 KR 20200108979
(71) Applicant: Heesung Electronics Co., Ltd, Seoul 04410 (KR)
(72) Inventor: CHO, Sung Ha, 16708 Suwon-si (KR)
(74) Representative: Mollekopf, Gerd Willi

(57) **Abstract**

The present disclosure discloses a method of manufacturing a cover bottom (100) for a display device, and in the cover bottom (100) for a display device, an edge of a metal plate (100') is bent into an L-shape to form a bezel part (120), and a thickness of the metal plate (100') forms a width of the bezel part (120).

## Description

### BACKGROUND OF THE INVENTION

### (a) Field of the Invention

The present disclosure discloses a cover bottom for a display device and a method of manufacturing the same.

### (b) Description of the Related Art

In general, display devices are devices configured to receive an image signal to display an image and include TVs, monitors, digital signage, smart phones, and the like, and as a device for displaying the image, various devices such as an organic light-emitting diode (OLED) device, a liquid crystal display (LCD) device, and a plasma display panel are used.

Recently, with development into an information society, the demand for display devices is changing in various forms, and the display devices are gradually becoming lighter, larger, and slimmer. In particular, as the demand for large-sized displays increases in the case of a display device applied to TVs, there is an increasing demand for lightening, slimming, and aesthetics of a TV structure together with a high-quality image and a high-definition image.

In general, a display device has a structure in which a display panel is adhered to a cover bottom (back cover) through a double-sided adhesive foam pad or the like so that the cover bottom supports the display panel.

Since the cover bottom supports a flat type display panel through a plate-shaped plate, the cover bottom should have high uniformity in flatness, and in particular, an edge part configured to cover a side surface of the display panel is required to have high straightness. When the edge part is bent, a small gap g is generated between the side surface of the panel and the edge part, and the width of the gap varies along an edge region, and thus the aesthetic appearance may be degraded, and the force to support the display panel may be decreased.

Meanwhile, a large screen of 65 inches or more has been generalized in recent display devices, and accordingly, the edge part also has a relatively long length, and thus, it is becoming relatively difficult to implement uniform straightness in an entire region of the edge part. That is, as the edge part of the cover bottom becomes longer, a spring-back phenomenon occurs easily during a bending process of the edge part, and thus it is difficult to maintain orthogonality (angle in a perpendicular direction) and straightness. In addition, as the display device becomes slimmer, the height of the edge part is also reduced, and thus the display device becomes very vulnerable to bending deformation.

Korean Registered Patent No. 10-1757723 (prior art document) discloses a method of manufacturing a module cover with excellent orthogonality of an edge part by applying an outer periphery forging process. However, according to the prior art document, excellent orthogonality is obtained by decreasing a curvature radius of a corner region of the edge part, but there is a limitation in that orthogonality with respect to the entire height of the edge part is not improved, and straightness of the edge part is also not improved.

As described above, the straightness and orthogonality with respect to the edge part of the cover bottom have a great influence on a large-sized screen and a slim display device, and in order to address this influence, a large number of processes have been applied, which causes problems such as an increase in process cost and a decrease in yield.

Meanwhile, in order to improve the orthogonality and straightness, a press process using a drawing forming apparatus may be applied to the edge part of the cover bottom. Drawing forming is advantageous in that a metal plate may be easily formed into various shapes but is problematic in that defects such as wrinkles or cracks are easily generated due to stress generated in the corner region in which vertical and horizontal directions intersect. In particular, recent display devices use an ultra-thin metal plate of about 1 mm as a material for the cover bottom to achieve slimness and lightness, and thus the wrinkles or cracks generated in the corner region become a great problem.

### SUMMARY OF THE INVENTION

The invention is defined in independent claims 1 and 5. Particular embodiments are set out in the dependent claims.

The present disclosure is directed to providing a cover bottom, which constitutes a large-screen flat display device, with excellent orthogonality and straightness of an edge part, and a method of manufacturing the same.

The present disclosure is also directed to providing a cover bottom, which constitutes a large-screen flat display device, allowing defects such as wrinkles and cracks generated in a corner region during a forming process of the cover bottom to be minimized or prevented, and a method of manufacturing the same.

The present disclosure is also directed to providing a cover bottom allowing a bezel width to be minimized by making a thickness of a metal plate constituting the cover bottom be a bezel width of a display device, and a method of manufacturing the same.

According to an aspect of the present disclosure, there is provided a cover bottom for a display device, wherein an edge of a metal plate is bent into an L-shape to form a bezel part, and a thickness of the metal plate forms a width of the bezel part.

The metal plate may be made of a high-strength steel sheet such as electrolytic galvanized iron (EGI), galvanized iron (GI), stainless steel (SUS), an Mg alloy, or the like having a yield strength of 170 MPa or more.

An inner corner part formed by bending the metal plate may form an inner groove concave toward an outer corner part, and the inner groove may be formed to be elongated in a longitudinal direction of the inner corner part.

A height of the bezel part may be equal to or less than 4.0 times the thickness of the metal plate or equal to or less than 5.0 mm.

According to another aspect of the present disclosure, there is provided a method of manufacturing a cover bottom configured to support a display panel, the method including, after a plate having a plate shape is prepared, (a) a press operation of forming an edge region of the plate into Z bending having a first horizontal part, a vertical part, and a second horizontal part, (b) a forging operation of improving horizontal and vertical characteristics of the first horizontal part, the vertical part, and the second horizontal part and improving a curvature radius of each of corner portions to which the first horizontal part, the vertical part, and the second horizontal part are connected, (c) an operation of removing the second horizontal part by applying a trimming process, and (d) an operation of processing an end of the vertical part from which the second horizontal part is removed.

The method may further include (e) an operation of correcting deformation of the vertical part by restriking using the forging process.

The method may further include (f) an operation of painting a surface of the plate.

The method may further include (g) an operation of coupling a user-defined mount (UDM) plate to a rear surface of the horizontal part.

The horizontal part and the UDM plate may be coupled to each other through a clinching process.

The operation (a) may include a process of forming a chamfer by removing a portion of a corner of the metal plate.

The operation (a) may include a process of forming a blocking protrusion part on the second horizontal part using a draw bead.

In the operation (a), the second horizontal part may be formed to have an inclined angle (α) toward the vertical part.

The inclined angle (α) may be in a range of 4° to 8°.

In the operation (b), an outer corner part to which the first horizontal part and the vertical part are connected and an outer corner part to which the vertical part and the second horizontal part are connected may have a curvature radius equal to or less than 0.5 times a thickness of the plate.

In the operation (c), the trimming process may be performed such that a protruding piece constituting a part of the second horizontal part remains.

The protruding piece may be formed to have a width of 0.05 mm to 0.2 mm.

It is to be understood that the features mentioned above and those yet to be explained below can be used not only in the respective combinations indicated, but also in other combinations or in isolation, without leaving the scope of the present invention. In particular, the features of the different aspects and embodiments of the cover bottom and the method of manufacturing a cover bottom can be combined with each other in any combination unless noted to the contrary.

### BRIEF DESCRIPTION OF THE DRAWINGS

The above and other objects, features, and advantages of the present disclosure will become more apparent to those of ordinary skill in the art by describing exemplary embodiments thereof in detail with reference to the accompanying drawings, in which:
- FIG. 1: is an exploded perspective view illustrating main components of a display device;
- FIG. 2: is a cross-sectional view of an edge part of a cover bottom, which is a major part of FIG. 1; and
- FIGS. 3 to 9: are process diagrams illustrating a process of manufacturing a cover bottom.

### DETAILED DESCRIPTION OF EXEMPLARY EMBODIMENTS

The present disclosure discloses a method of manufacturing a cover bottom for a display device, and in the cover bottom for a display device of the present embodiment, an edge of a metal plate is bent into an L-shape to form a bezel part, and a thickness of the metal plate forms a width of the bezel part.

The technical objectives achieved by the present disclosure and the embodiments of the present disclosure will be apparent from exemplary embodiments described below. Hereinafter, the exemplary embodiments of the present disclosure will be described in detail with reference to the accompanying drawings.

It is to be understood that the differences in the embodiments described below are not mutually exclusive. That is, it is to be understood that the specific shapes, structures, and characteristics described may be implemented in other embodiments in connection with one embodiment and that the location or arrangement of individual components within each disclosed embodiment may be changed without departing from the scope of the present disclosure. In the drawings, like reference numerals refer to the same or similar functionality throughout various aspects, and lengths, areas, thicknesses, and the like and the forms thereof may be exaggerated for convenience. In the description of the present embodiment, expressions, such as up, down, left, right, front, and rear, indicate relative positions or directions, and technical significance will not be bound by the dictionary meanings.

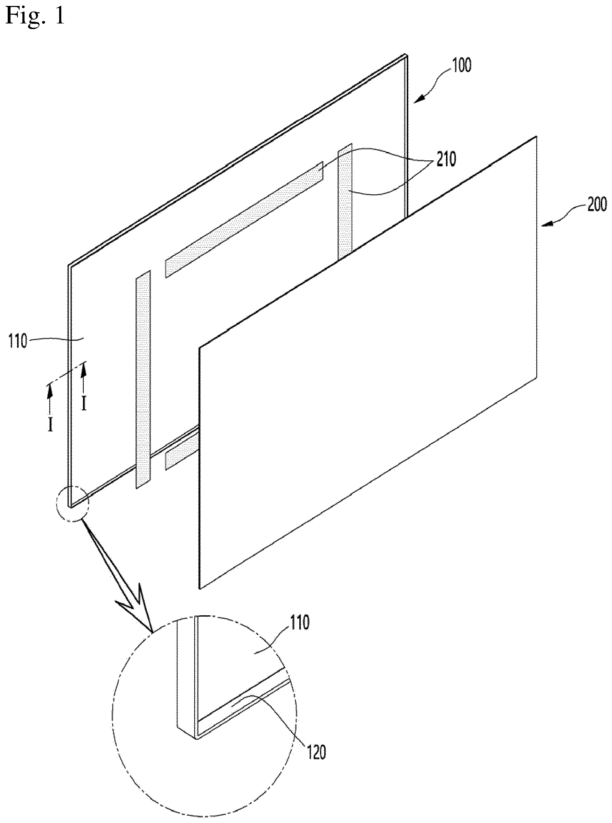

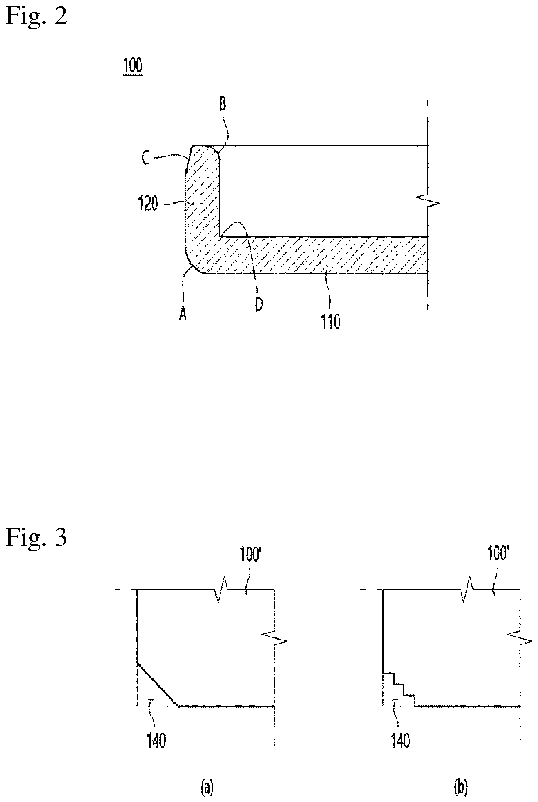

FIG. 1 is an exploded perspective view illustrating main components of a display device, and FIG. 2 is a cross-sectional view of an edge part of a cover bottom, which is a major part of FIG. 1.

Referring to these drawings, the display device includes a cover bottom 100 and a display panel 200 coupled to the cover bottom at a front surface of the cover bottom. The display panel 200 may be bonded to an inner surface of the cover bottom using an adhesive member 210 such as a double-sided adhesive tape.

Here, the display panel 200 is a key component of the display device and is an image display element configured to express an image from external signals and may be constituted by, for example, an organic light-emitting panel. The organic light-emitting panel is advantageous for slimming and a curved surface and exhibits a fast response time.

In addition, the display panel 200 may be constituted by various types of image display elements such as a liquid crystal panel, a plasma panel, and the like in addition to the organic light-emitting panel. When the display panel 200 is constituted by the liquid crystal panel, a backlight unit configured to provide a surface light source may be further coupled to a rear surface of the liquid crystal panel.

The cover bottom 100 is a metal plate having a plate shape and is made of a material having sufficient rigidity while being lightweight. The metal plate applied to the cover bottom is composed of a plate made of a high-strength steel sheet such as electrolytic galvanized iron (EGI), galvanized iron (GI), stainless steel (SUS), an Mg alloy, or the like having a yield strength of 170 MPa or more.

Further, the cover bottom 100 includes a support part 110, which has a rectangular plate region and is configured to support the display panel 200 by being coupled to a rear surface of the display panel 200, and an edge part 120 configured to guide and protect the coupling of the display panel 200 while shielding side surfaces of the display panel 200.

The edge part 120 may be formed by bending an edge of the support part 110 toward the front and has a predetermined height corresponding to a thickness of the display panel 200. The edge part 120 should be pressed against the side surfaces of the display panel 200 so that a predetermined distance between the edge part 120 and the display panel 200 is maintained in an entire region of the rectangular edge. To this end, in the edge part 120, a corner portion to be bent should have little curvature, and an upper end portion should be maintained in orthogonality and straightness.

Referring to FIG. 2, the cover bottom 100 is composed of the support part 110 and the edge part 120, and a curved surface is formed on each of corner parts A and B of the edge part 120 which are an outer lower end and an inner upper end of the edge part 120. At this point, the curved surfaces formed on the corner parts A and B of outer and inner sides of the cover bottom 100 have a curvature radius of 0.5 mm to 1.2 mm with respect to the cover bottom 100 having a thickness of 1.2 mm. Accordingly, when the edge part 120 is bent from the support part 110, since a bending region has a curvature less than or equal to a material thickness, a bezel having a sharp edge may be implemented.

Further, the edge part 120 may have an outer upper end C with a chamfer structure. The chamfer structure may be formed by processing a cut surface of the edge part 120 by wheel cutting or through a press process using a forming apparatus having a chamfer shape. The chamfer structure may be finished such that a sharp end of the edge part 120 is smooth to improve aesthetics.

Further, the edge part 120 may have a groove structure in which a lower inner corner part D is concave. The groove structure may be formed to be elongated along a connection part of the support part 110 and the edge part 120. The groove structure of the lower inner corner part D may be formed in a forging process using a forming apparatus, and the display panel 200 may be pressed against the support part 110 and the edge part 120 in a process of coupling the display panel 200.

Main processes for manufacturing the cover bottom are summarized and shown in Table 1.

| [Table 1] | | | | | | |
|---|---|---|---|---|---|---|
| Clas sific atio n | First process | Second process | Third process | Fourth process | Fifth process | Post process |
| App arat us | Press (forming) | | | | | Painting |
| Proc ess | Forming /Z bending | First forging | Trimming /Cutting | Second forging + Chamfer | Re-striking | Powder painting |
| | 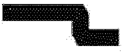 | 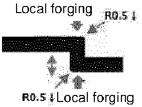 | 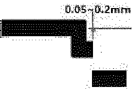 | 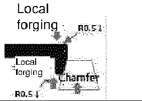 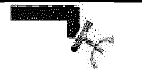 | 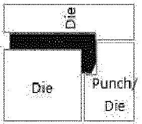 | 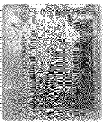 |

Referring to Table 1, the main processes for manufacturing the cover bottom include a first process for Z-bending, a second process for local forging, a third process for trimming, a fourth process for local finishing, a fifth process for compensation, and a post process for painting.

The first process is a process of realizing a product shape, and a draw bead may be added to prevent bending, distortion, or the like of the metal plate. In the second process, first forging is locally applied to reduce a curvature radius R of the corner part of the product. The third process is a cutting process for minimizing a Z-bending region. The fourth process is a process of removing cut protrusions and burrs of a corner, and a second forging process and a wheel cutting process may be selectively applied or both thereof may be applied. The fifth process is a process in which a dimension or bending is corrected and may be omitted when a dimension change or bending does not occur in the first to fourth processes. In the post process, an exterior of the product is painted.

Hereinafter, a process of manufacturing a cover bottom to this end will be described in detail with reference to an embodiment.

FIGS. 3 to 9 are process diagrams illustrating the process of manufacturing the cover bottom, and (a) of each drawing illustrates a processing process using an apparatus, and (b) thereof conceptually illustrates the shape of the cover bottom after the process is performed.

FIG. 3 is a plan view illustrating a metal plate for manufacturing the cover bottom. The cover bottom is formed into a predetermined shape by applying pressing, punching, drawing, and the like to a metal plate 100' having a plate shape. At this point, relatively greater stress may be applied to a specific region of the metal plate 100', particularly, to a corner region than to other regions, and defects such as wrinkles, distortion, cracks, or the like may be generated due to the stress.

The cover bottom is chamfered, that is, a portion of the corner of the metal plate 100' is removed as illustrated in the drawings, in order to prevent the defects caused by the stress during the manufacturing process. That is, a cover bottom 100 is manufactured through a process in which a Z-bending process is applied after the chamfering process is applied for the metal plate 100'. A chamfered region 140 prevents the defects by dispersing or blocking stress of a weakened portion of the corner when the metal plate is formed. The chamfered region 140 may be formed by removing the corner of the metal plate 100' in a diagonal direction as shown in FIG. 3A or by removing the corner to form a stair structure as shown in FIG. 3B.

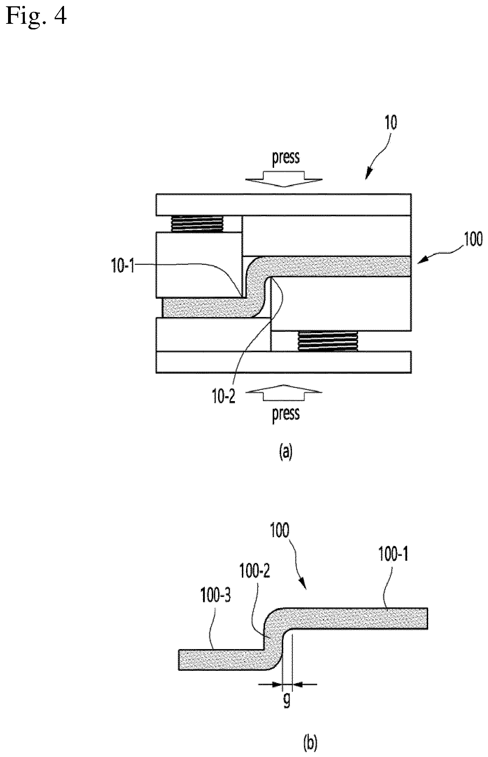

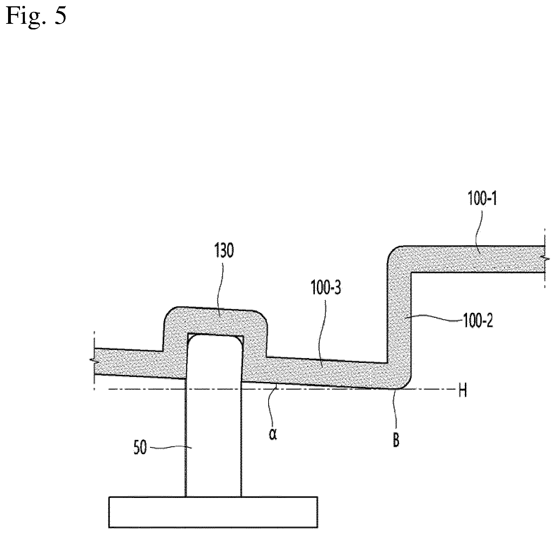

FIG. 4 illustrates a Z-bending process, and FIG. 5 illustrates a process of forming a blocking protrusion part using a draw bead.

First, referring to FIG. 4, after the plate-shaped metal plate is chamfered, four edges are bent to the front using a press-forming apparatus 10. At this point, the edge of the plate is bent to have a shape of 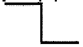 and includes a first horizontal part 100-1, a vertical part 100-2, and a second horizontal part 100-3. That is, in the bending process, Z bending is applied. The first horizontal part 100-1 constitutes the support part 110, and the vertical part 100-2 constitutes the edge part 120.

The press-forming apparatus for the Z bending should have a curved shape having a predetermined curvature radius at each of a lower corner part 10-1 of an upper die and an upper corner part 10-2 of a lower mold, which press the metal plate. As an example, for a 1.2 mm thick metal plate, each of the corner parts 10-1 and 10-2 of the forming apparatus 10 has a curvature radius of 0.6 to 1.2 mm. That is, each of the corner parts 10-1 and 10-2 of the forming apparatus 10 may have a curvature radius of 0.5 to 1.0 times a thickness of the metal plate. When the curvature radius is less than 0.5 times, defects such as tearing of the metal plate may occur during a press process, and when the curvature radius is greater than 1.0 times, forming may not be easily performed.

As described above, by applying a Z-bending structure, the vertical part 100-2 is supported by the second horizontal part 100-3 in addition to the first horizontal part 100-1 at both sides of upper and lower ends so that a spring back phenomenon may be minimized in subsequent forging, trimming, and wheel cutting processes.

Meanwhile, in the Z-bending process, the thin metal plate may be easily bent or distorted. In order to prevent this, a process of forming a blocking protrusion part 130 may be simultaneously performed using a draw bead 50. As illustrated in FIG. 5, the blocking protrusion part 130 is formed at a predetermined position of the second horizontal part 100-3 using the draw bead 50. The blocking protrusion part 130 is formed to prevent stress, which is generated from the outside when a press or forging process is applied to the metal plate, from being transmitted to the bending region.

In general, when a press or forging process is applied to a thin metal plate, stress may be generated in the plate such that the plate itself may be bent or distorted. Such bending or distortion may affect the first horizontal part 100-1 and the vertical part 100-2 and thus the first horizontal part 100-1 and the vertical part 100-2 may be deformed in flatness, orthogonality, straightness, and the like. As described above, the blocking protrusion part 130 prevents the external force from being transmitted to the first horizontal part 100-1 and the vertical part 100-2, thereby preventing the deformation of the first horizontal part 100-1 and the vertical part 100-2.

Further, in the Z-bending process, the second horizontal part 100-3 is bent to have a predetermined inclined angle α toward the vertical part 100-2. That is, an acute angle may be formed between the vertical part 100-2 and the second horizontal part 100-3, and the second horizontal part 100-3 has an inclined angle α of about 4° to 8° with respect to a reference line H in a horizontal direction.

As described above, when the second horizontal part 100-3 has the inclined angle toward the vertical part 100-2, a curvature radius of an outer corner part B formed at a connection part of the vertical part 100-2 and the second horizontal part 100-3 may be easily reduced, and a height of the vertical part 100-2 may also be easily reduced. That is, in the forging process, the forming apparatus may come into contact with the outer corner part B first and the force applied from the forming apparatus may be concentrated on the outer corner part B so that the curvature radius of the outer corner part B and the height of the vertical part 100-2 may be relatively easily reduced.

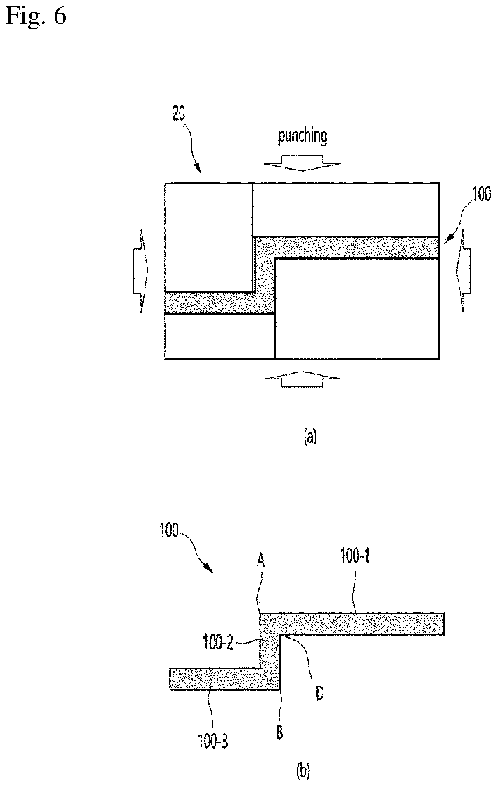

FIG. 6 illustrates a first forging process. After the Z-bending process, the first forging process is applied as illustrated in FIG. 6. In the forging process, a punching process is repeatedly applied to the first horizontal part 100-1, the vertical part 100-2, and the second horizontal part 100-3 using a punching apparatus 20. In the forging process, flatness of each of the first horizontal part 100-1 and the second horizontal part 100-3 is improved, and orthogonality and straightness of the vertical part 100-2 are improved. In addition, during the forging process, a curvature radius of each of an outer corner part A to which the vertical part 100-2 and the first horizontal part 100-1 are connected, the outer corner part B to which the vertical part 100-2 and the second horizontal part 100-3 are connected, and an inner corner part D to which the vertical part 100-2 and the first horizontal part 100-1 are connected is reduced to a minimum.

In general, the first horizontal part 100-1, the vertical part 100-2, and the second horizontal part 100-3 are formed by Z bending using a forming press, but the flatness of each of the first horizontal part 100-1 and the second horizontal part 100-3 is poor, and the orthogonality and straightness of the vertical part 100-2 are incomplete. Thus, by applying the forging process, the flatness of each of the first horizontal part 100-1 and the second horizontal part 100-3 is improved, and the orthogonality and straightness of the vertical part 100-2 are improved.

Further, in the bending process using the forming press, each of the corner part to which the vertical part 100-2 and the first horizontal part 100-1 are connected and the corner part to which the vertical part 100-2 and the second horizontal part 100-3 are connected does not form a right angle and has a predetermined curvature radius.

In particular, in the curved connection part formed between the first horizontal part 100-1 and the vertical part 100-2 constituting the support part 110, when the display panel 200 is pressed against the edge part 120, a curved surface formed on the inner corner part D interferes with an edge of the panel, and thus the display panel 200 may be prevented from being pressed against the edge part 120 and a predetermined gap g (see FIG. 4) may be formed therebetween. The gap g is not only disadvantageous in reducing a bezel area of the display device but also becomes a factor degrading an external shape. In addition, the curved surface formed on each of the outer corner parts A and B prevents the display device from forming a perfect right angle, and thus a design representing an edge feeling may not be realized.

As described above, the flatness of each of the first horizontal part and the second horizontal part and the orthogonality and straightness of the vertical part may be improved using the forging process, and by minimizing the curvature radius of the corner part to which the first horizontal part and the second horizontal part are connected, the edge part 120 of the cover bottom 100 may be pressed against the display panel 200, and an edge feeling for the edge part 120 may be provided.

Further, by using the forging process, the vertical part 100-2 may have a lowered height and may be uniformly aligned along an entire longitudinal direction. As an example, the vertical part 100-2 has a height of about 4.3 mm in the Z-bending process but has a uniform height while being lowered to 2.8 mm to 4.0 mm by the forging process.

Further, the curvature radius appearing at each of the outer corner parts A and B may be reduced to 0.6 mm or less through the forging process. That is, the curvature radius of each of the outer corner parts A and B may be reduced to 0.5 times or less of the thickness of the metal plate through the forging process.

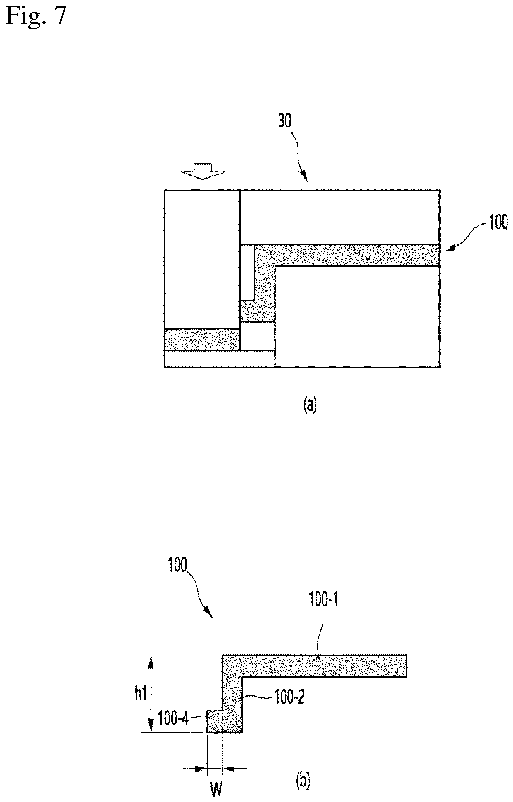

FIG. 7 illustrates a trimming process of removing the second horizontal part. After the first forging process, a portion of the second horizontal part 100-3 is cut and removed using a trimming apparatus 30. At this point, as illustrated in FIG. 7, the trimming process is performed so that a protruding piece 100-4 constituting a portion of the second horizontal part 100-3 remains at an end of the vertical part 100-2. The protruding piece 100-4 continuously supports the vertical part 100-2 so that bending deformation does not occur in a subsequent wheel cutting process.

It is advantageous in supporting the vertical part 100-2 that the protruding piece 100-4 is formed as wide as possible, but there is a disadvantage in that the wheel cutting process becomes difficult. In addition, when the protruding piece 100-4 is formed with a width that is too narrow, there is a high risk that the vertical part 100-2 is rubbed by the trimming apparatus, and in this case, there is a disadvantage in that the vertical part 100-2 should be processed again.

Accordingly, a width w of the protruding piece 100-4 may not be greater than the thickness of the metal plate, that is, 1.2 mm, but may be formed at a ratio of 1 to 10% with respect to a height h1 of the vertical part 100-2. As an example, the vertical part 100-2 has a height H1 of 4.0 mm, and the protruding piece 100-4 is formed with a width w of 0.05 mm to 0.2 mm.

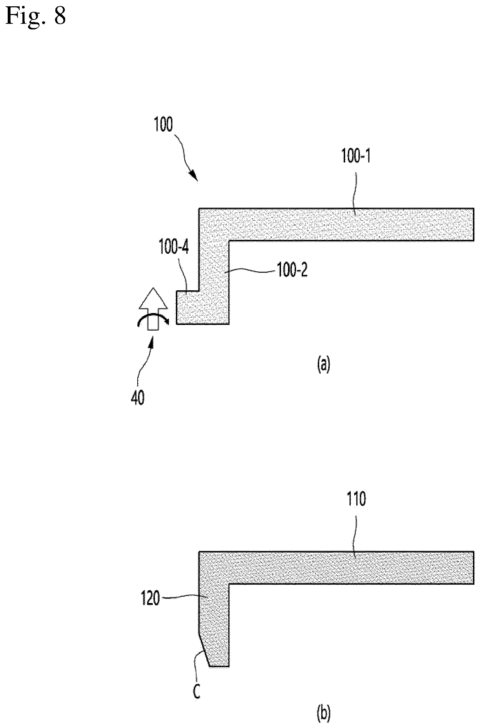

FIG. 8 illustrates a process of removing cut protrusions and burrs of the vertical part 100-2. As illustrated in FIG. 8, the protruding piece 100-4 and the burrs are removed through a computerized numerically controlled (CNC) process using a wheel cutter 40, thereby manufacturing the cover bottom 100 having the support part 110 and the edge part 120. At this point, an end of the support part 110 may be processed to have an inclined surface, a curved surface, or a vertical surface, or various shapes according to the type of the wheel cutter 40.

Since the protruding piece 100-4 is removed through the CNC process as described above, a chamfer structure having an inclined or curved surface shape may be formed at an outer corner part C of the edge part 120, but the chamfer structure may also be formed at the outer corner part C by applying the forging process after the protruding piece 100-4 is removed. At this point, when a second forging process is applied, the curvature radius of the outer corner part A to which the first horizontal part 100-1 and the vertical part 100-2 are connected may be further improved, and in particular, the height of the vertical part 100-2 may be reduced to 3.6 mm or less, and preferably 3.0 mm or less. That is, the height of the vertical part 100-2 may be adjusted through two forging processes. The height of the vertical part 100-2 may be equal to or less than 4.0 times the thickness of the metal plate in consideration of the thinning of the display device or equal to or less than 5.0 mm.

In a process of finishing the end of the edge part 120, the forging process may be applied instead of the CNC process, or both the CNC process and the forging process may be applied.

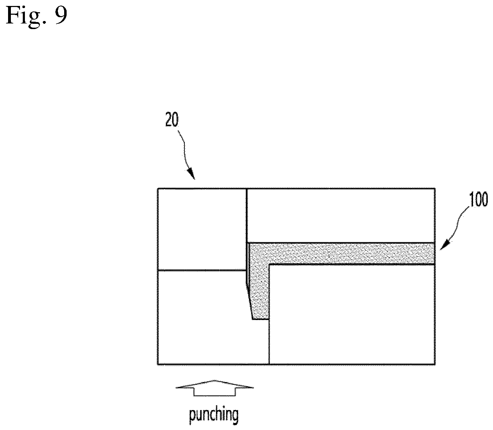

FIG. 9 illustrates a restriking process. As illustrated in FIG. 9, after the wheel cutting process is applied, the restriking process may be further applied. The cover bottom 100 may be changed in dimension and may be deformed by bending through the Z-bending process, the forging process, the trimming process, and the end finishing process, and such dimensional changes or bending deformation are corrected by the restriking process.

In addition, a painting process is applied to the formed cover bottom 100. Through the painting process, a pressed mark generated during the press and forging processes or an exposed portion of the chamfered region is covered, and the surface is decorated. In the painting process, powder painting or liquid painting may be used.

A thickness of a plate material of the cover bottom manufactured through the above-described processes forms a bezel width of the display device so that the bezel width may be minimized, and the orthogonality and straightness of the edge part may be improved, thereby protecting the external shape of the display device.

Meanwhile, although not illustrated in the drawings, a process of coupling a user-defined mount (UDM) plate (not shown) to a rear surface of the cover bottom, on which the forming is completed, may be performed. The UDM plate is a component in which various control modules such as a speaker module, a power module, a graphic module, and a thermocouple (TC) module are combined. The UDM plate may be coupled to the cover bottom through a clinching process. Since the UDM plate and the cover bottom are composed of an ultra-thin metal plate, a coupling force thereof may be improved through the clinching process even without a separate fastening means.

According to a method of manufacturing a cover bottom of the present disclosure, an edge part of the cover bottom has excellent orthogonality and straightness so that an external shape of a side surface of a display device can be protected.

Further, according to a method of manufacturing a cover bottom of the present disclosure, defects such as wrinkles or cracks generated in a corner region during a forming process of a metal plate can be prevented so that defects of a product can be minimized.

Further, according to a method of manufacturing a cover bottom of the present disclosure, a thickness of a metal plate forms a bezel width of a display device so as to be advantageous in reducing the bezel width.

Further, according to a method of manufacturing a cover bottom of the present disclosure, an edge part can be processed with a minimum height so as to be advantageous in thinning of a display device.

While exemplary embodiments of the present disclosure have been illustrated and described as described above, various modifications and equivalent other embodiments may be made by those skilled in the art. These modifications and other embodiments will all be considered and included in the appended claims and do not depart from the true scope of the present disclosure.

## Claims

1. A cover bottom (100) for a display device, wherein
an edge of a metal plate (100') is bent into an L-shape to form a bezel part (120), and
a thickness of the metal plate (100') forms a width of the bezel part (120).

2. The cover bottom (100) for a display device of claim 1, wherein the metal plate (100') is made of a high-strength steel sheet such as electrolytic galvanized iron (EGI), galvanized iron (GI), stainless steel (SUS), an Mg alloy, or the like having a yield strength of 170 MPa or more.

3. The cover bottom (100) for a display device of claim 1 or 2, wherein
an inner corner part (D) formed by bending the metal plate (100') forms an inner groove concave toward an outer corner part (A), and
the inner groove is formed to be elongated in a longitudinal direction of the inner corner part (D).

4. The cover bottom (100) for a display device of claim 1, 2 or 3, wherein a height of the bezel part (120) is equal to or less than 4.0 times the thickness of the metal plate (100') or equal to or less than 5.0 mm.

5. A method of manufacturing a cover bottom (100) configured to support a display panel (200), the method comprising;
after a plate (100') having a plate shape is prepared,
(a) a press operation of forming an edge region of the plate (100') into Z bending having a first horizontal part (100-1), a vertical part (100-2), and a second horizontal part (100-3);
(b) a forging operation of improving horizontal and vertical characteristics of the first horizontal part (100-1), the vertical part (100-2), and the second horizontal part (100-3) and improving a curvature radius of each of corner portions to which the first horizontal part (100-1), the vertical part (100-2), and the second horizontal part (100-3) are connected;
(c) an operation of removing the second horizontal part (100-3) by applying a trimming process; and
(d) an operation of processing an end of the vertical part (100-2) from which the second horizontal part (100-3) is removed.

6. The method of claim 5, further comprising (e) an operation of correcting deformation of the vertical part (100-2) using a restriking process.

7. The method of claim 5 or 6, further comprising (f) an operation of painting a surface of the plate (100').

8. The method of any of claims 5 to 7, further comprising (g) an operation of coupling a user-defined mount (UDM) plate to a rear surface of the horizontal part (100-1).

9. The method of claim 8, wherein the horizontal part (100-1) and the UDM plate are coupled to each other through a clinching process.

10. The method of any of claims 5 to 9, wherein the operation (a) includes a process of forming a chamfer (140) by removing a portion of a corner of the metal plate (100').

11. The method of any of claims 5 to 10, wherein the operation (a) includes a process of forming a blocking protrusion part (130) on the second horizontal part (100-3) using a draw bead (50).

12. The method of any of claims 5 to 11, wherein, in the operation (a), the second horizontal part (100-3) is formed to have an inclined angle (α) toward the vertical part (100-2).

13. The method of claim 12, wherein the inclined angle (α) is in a range of 4° to 8°.

14. The method of any of claims 5 to 13, wherein, in the operation (b), an outer corner part (A) to which the first horizontal part (100-1) and the vertical part (100-2) are connected and an outer corner part (B) to which the vertical part (100-2) and the second horizontal part (100-3) are connected have a curvature radius equal to or less than 0.5 times a thickness of the plate (100').

15. The method of any of claims 5 to 14, wherein, in the operation (c), the trimming process is performed such that a protruding piece (100-4) constituting a part of the second horizontal part (100-3) remains; wherein in particular the protruding piece (100-4) is formed to have a width of 0.05 mm to 0.2 mm.
